# EUROPÄISCHE PATENTSCHRIFT

(11) **EP 2 993 675 B1**
(45) Veröffentlichungstag und Bekanntmachung des Hinweises auf die Patenterteilung: **12.04.2017**
(21) Anmeldenummer: 15179900.4
(22) Anmeldetag: 05.08.2015
(51) Int. Cl.: H01F 17/06, H01F 27/26

(54) **FILTERBAUTEIL MIT WICKLUNGSLOSEN MAGNETISCHEM RINGKERN**
FILTER COMPONENT WITH WINDINGLESS MAGNETIC TOROIDAL CORE
COMPOSANT DE FILTRE DOTE DE NOYAU TOROÏDAL MAGNETIQUE SANS ENROULEMENT

(30) Priorität: 02.09.2014 DE 102014112614
(43) Veröffentlichungstag der Anmeldung: 09.03.2016
(73) Patentinhaber: SCHAFFNER EMV AG, 4542 Luterbach (CH)
(72) Erfinder: Meier, Samuel, 4553 Subingen (CH); Ackermann, Christian, 4500 Solothurn (CH)
(74) Vertreter: P&TS SA (AG, Ltd.)

(56) Entgegenhaltungen:
- JP-A- H07 230 915
- JP-A- 2014 096 538

## Beschreibung

### Technisches Gebiet

Die Erfindung bezieht sich auf ein Filterbauteil mit einem wicklungslosen Ringkern, eine Filterbaugruppe mit einer Mehrzahl der Filterbauteile, eine Filterbaugruppe und ein Verfahren zur Befestigung der Filterbaugruppe bzw. des Filterbauteils.

### Stand der Technik

In Filtern werden oft gewickelte oder wicklungslose Ringkerne verwendet.

Gewickelte Ringkerne benötigen oft ein Gehäuse, welches auf einem Befestigungselement, z.B. einer Platine oder einer Grundplatte, befestigt ist. Des Weiteren benötigen diese gewickelten Ringkerne oft einen Anschluss, um den Leiter mit der Wicklung des Ringkerns zu verbinden. Die Dokumente EP0650172, CN202771896U, FR2147816, EP1807847, CN103680848, CN202732471 U, DE69407728T und DE102004025114 offenbaren solche gewickelten Ringkerne, die in Richtung der Längsachse der Ringöffnung in ein Ringkerngehäuse eingeführt werden. In DE102004025114 wird der Ringkern durch einen Schnappmechanismus in dem Ringkerngehäuse gehalten.

Alternativ werden wicklungslose Ringkerne verwendet. Diese sind besonders einfach, da der Leiter einfach durch die Öffnung des Ringkerns geführt wird bzw. der Ringkern um den Leiter geschlossen wird. Danach wird der Ringkern an dem Leiter befestigt. Dies geschieht in der Regel durch Vergiessen des Ringkerns mit dem Leiter. Ein solches Vergiessen des Ringkerns mit dem Leiter ist aber aufwendig. Alternativ gibt es auch Klappkerne, bestehend aus zwei Hohlzylinderhälften, die um einen Leiter durch Zusammenpressen befestigt werden. Allerdings sind diese Klappkerne komplex in der Herstellung und erfordern für jede Kerngrösse einen neuen Klappkern. Die Dokumente JP0H08167524, US6118077, DE4223044, JP2007266214, US5506909, EP2753161, US20130222103 und DE19730108 offenbaren solche Klappkerne, wobei jede Kernhälfte mit einem Schnappmechanismus in einem klappbaren Gehäuse befestigt ist, welches im geschlossenen Zustand den Leiter umgreift.

Das Dokument JPH07230915 offenbart eine Mehrzahl wickelungsloser Ringkerne, die jeweils in einem Ringkerngehäuse gehalten sind. Die Ringkerngehäuse können hintereinandergeschaltet werden, so dass Ringkerne verschiedener Größe modular zusammengebaut werden können. Allerdings ist die Montage eines Ringkerns in das Ringkerngehäuse aufwendig, da der Ringkern von einem Gehäusedeckel gehalten wird, dessen Montage aufwendig ist, aber für die Verbindung mit dem nächsten Ringkerngehäuse notwendig ist.

Das Dokument JP2014096538A offenbart ebenfalls eine Mehrzahl wickelungsloser Ringkerne, die paarweise jeweils in einem Ringkerngehäuse gehalten sind. Auch hier können die Ringkerngehäuse hintereinandergeschaltet werden, so dass Ringkerne verschiedener Größe modular zusammengebaut werden können. Für die Montage eines Ringkerns ist ebenfalls ein Gehäusedeckel notwendig. Die Gruppe zusammengebauter Ringkerne kann über eine Montageoberfläche an einer Befestigungsfläche befestigt werden.

### Darstellung der Erfindung

Es ist ein Ziel der Erfindung, ein Filterbauteil mit einem wicklungslosen Ringkern zu finden, das einfach herzustellen ist, modular einsetzbar ist und/oder einfach zu montieren ist.

In einem Ausführungsbeispiel wird dieses Ziel mit einem Filterbauteil nach Anspruch 1 gelöst, das folgendes aufweist: Einen wicklungslosen magnetischen Ringkern mit einer zentralen Öffnung. Ein Ringkerngehäuse, in dem der Ringkern mit einem Schnappmechanismus befestigt ist, der so ausgebildet ist, dass der Ringkern in Richtung einer Längsachse der Öffnung des Ringkerns in das Ringkerngehäuse gesteckt werden kann und der einen oder mehrere bewegliche Hebel aufweist, die so geformt sind, dass sich der oder die bewegliche(n) Hebel beim Drücken des Ringkerns gegen das Ringkerngehäuse öffnen, und nach dem Einschnappen des oder der beweglichen Hebel den Ringkern halten. Das Filterbauteil ist dabei so ausgebildet, dass ein Leiter wicklungslos durch die Öffnung des in dem Ringkerngehäuse befestigten Ringkerns geführt werden kann.

Der Schnappmechanismus erlaubt einen einfachen Zusammenbau des Filterbauteils ohne die Notwendigkeit eines Vergießens des Ringkerns mit dem Leiter. Zusätzlich kann der Ringkern über das Gehäuse an einem Befestigungselement befestigt werden und der Leiter auch nachträglich durch die Öffnung des Ringkerns geführt werden. Allerdings kann das Filterbauteil in manchen Fällen natürlich auch an dem Leiter befestigt werden.

In einem Ausführungsbeispiel wird dieses Ziel mit einer Filterbaugruppe nach Anspruch 13 mit einer Mehrzahl an den oben beschriebenen Filterbauteilen gelöst. Jedes Filterbauteil weist einen wicklungslosen magnetischen Ringkern mit einer Öffnung und ein Ringkerngehäuse zum Befestigen des Ringkerns auf. Die Filterbauteile sind so aneinandergereiht, dass die Öffnungen der magnetischen Ringkerne der Filterbauteile eine durchgehende Öffnung für einen Leiter ausbilden.

Eine solche Filterbaugruppe erlaubt ein modulares Vergrössern des Ringkerns mit dem gleichen Filterbauteil durch Hintereinanderreihung dieser Filterbauteile. Gleichzeitig lässt sich jedes Filterbauteil der Filterbaugruppe durch dessen Ringkerngehäuse individuell befestigen. Somit kann eine montierte Filterbaugruppe auch durch Hinzufügen eines weiteren Filterbauteils vergrössert werden, ohne die anderen Filterbauteile zu entfernen. Genauso kann eine Filterbaugruppe verkleinert werden, in dem eines der Filterbauteile entfernt wird. Dafür muss nur das eine Filterbauteil gelöst werden. Dies ist insbesondere vorteilhaft in Kombination mit den einschnappenden Ringkernen in den Ringkerngehäusen wie oben beschrieben. Die Verwendung eines Gehäuses für jeden Ringkern hat weiterhin den Vorteil, dass keine verschiedenen Gehäuse für verschiedene Ringkernanzahlen vorgesehen werden müssen.

In einem Ausführungsbeispiel wird dieses Ziel durch ein System nach Anspruch 14 erreicht. Das System weist ein Befestigungselement, mindestens eine der beschriebenen Filterbauteile oder eine der beschriebenen Filterbaugruppen auf. Das mindestens eine Filterbauteil oder die Filterbaugruppe ist auf dem Befestigungselement befestigt. Das System weist weiter einen Leiter auf, der wicklungslos durch die Öffnung jedes Ringkerns des mindestens einen Filterbauteils oder der Filterbaugruppe geführt ist.

In einem Ausführungsbeispiel wird dieses Ziel durch ein Verfahren nach Anspruch 15 erreicht, aufweisend die Schritte: Befestigen einer Filterbaugruppe oder eines Filterbauteils wie oben beschrieben auf einem Befestigungselement und Durchführen eines Leiters durch eine Öffnung des Ringkerns oder der Ringkerne nach dem Befestigen der Filterbaugruppe oder des Filterbauteils.

Die Idee, wicklungslose Ringkerne durch ein Gehäuse auf einem Befestigungselement zu befestigen, vermeidet die umständliche Verbindung der Ringkerne mit dem Leiter, insbesondere für eine grössere Anzahl von Ringkernen. Gleichzeitig kann das System fertig installiert werden, bevor der Leiter durch die Ringkerne geführt wird.

Weitere vorteilhafte Ausführungsformen sind in den abhängigen Ansprüchen angegeben.

In einem Ausführungsbeispiel weist der Schnappmechanismus mehrere elastische Klammern auf, die so geformt sind, dass sich die Klammern beim Drücken des Ringkerns gegen das Ringkerngehäuse öffnen, und die nach dem Einschnappen der Klammern den Ringkern halten.

In einem Ausführungsbeispiel ist der Ringkern in einer dem Ringkern entsprechenden Ausnehmung des Ringkerngehäuses angeordnet.

In einem Ausführungsbeispiel weist das Ringkerngehäuse eine Innenwandung auf, die die Wandung in der Öffnung des Ringkerns bedeckt, und eine Aussenwandung auf, die die der Öffnung gegenüberliegende äussere Wandung des Ringkerns bedeckt. Dadurch ist der Ringkern gegenüber dem Leiter und nach aussen isoliert.

In einem Ausführungsbeispiel weist das Ringkerngehäuse eine erste Befestigungsfläche zur Befestigung des Ringkerngehäuses auf, die parallel zu einer Längsachse der Öffnung des Ringkerns angeordnet ist.

In einem Ausführungsbeispiel weist das Ringkerngehäuse eine zweite Befestigungsfläche zur Befestigung eines weiteren Bauteils auf dem Ringkerngehäuse auf, die parallel zu der Längsachse der Öffnung des Ringkerns angeordnet ist.

In einem Ausführungsbeispiel ist die erste Befestigungsfläche parallel zu der zweiten Befestigungsfläche angeordnet.

In einem Ausführungsbeispiel weist die erste Befestigungsfläche und/oder die zweite Befestigungsfläche Ausnehmungen für Befestigungsmittel auf. Befestigungsmittel sind vorzugsweise Nieten oder Schrauben. In einem Ausführungsbeispiel ist die Ausnehmung sowohl für die Befestigung von Nieten als auch für das Einführen einer Mutter zur Befestigung einer Schraube geeignet.

In einem Ausführungsbeispiel weist die erste Befestigungsfläche zwei Ausnehmungen für Befestigungsmittel und vier vorspringende Standfüße zur Vergrösserung der Standfläche auf.

In einem Ausführungsbeispiel weist das Ringkerngehäuse eine Ringkernseite zum Einführen des Ringkerns und eine der Ringkernseite gegenüberliegende Ringkernrückseite auf, wobei die Ringkernseite zwei in Richtung der Längsachse der Öffnung vorspringende Standfüße aufweist und die Ringkernrückseite zwei in Richtung der Längsachse der Öffnung vorspringende Standfüße aufweist, die zu den zwei Standfüßen der Ringkernseite versetzt angeordnet sind, wobei die Ringkernseite zwei Standfußausnehmungen für die Aufnahme jeweils eines Standfußes aufweist, die gegenüber den zwei Standfüßen der Ringkernrückseite angeordnet sind, und die Ringkernrückseite zwei Standfußausnehmungen für die Aufnahme jeweils eines Standfußes aufweist, die gegenüber den zwei Standfüßen der Ringkernseite angeordnet sind. So kann die Standfläche eines einzelnen Ringkerngehäuses vergrössert werden, ohne die effektive Breite des Ringkerngehäuses in einem Stapel von Ringkerngehäusen zu vergrössern. Gleichzeitig erlaubt die formschlüssige Aufnahme der Standfüße die Übertragung axialer Kräfte von einem Ringkerngehäuse zu dem nächsten. Dies stabilisiert modular zusammengesteckte Ringkerngehäuse.

In einem Ausführungsbeispiel weist das Ringkerngehäuse eine Ringkernseite zum Einführen des Ringkerns und eine der Ringkernseite gegenüberliegende Ringkernrückseite auf, wobei die Ringkernseite und die Ringkernrückseite des Ringkerngehäuses so ausgebildet sind, dass, wenn das Filterbauteil mit der Ringkernseite im Anschluss an eine Ringkernrückseite eines baugleichen Filterbauteils angeordnet ist, eine zu der Längsachse der Öffnung des Ringkerns radiale relative Bewegung der Filterbauteile zueinander durch Formschluss verhindert wird.

In einem Ausführungsbeispiel sind die Ringkernseite und die Ringkernrückseite des Ringkerngehäuses so ausgebildet, dass, wenn das Filterbauteil mit der Ringkernseite im Anschluss an eine Ringkernrückseite eines baugleichen Filterbauteils angeordnet ist, die Anordnung nur in einer Positionierung möglich ist.

In einem Ausführungsbeispiel weisen die Ringkernseite und die Ringkernrückseite des Ringkerngehäuses jeweils mindestens ein Befestigungsrastelement auf, das, wenn das Filterbauteil mit der Ringkernseite im Anschluss an eine Ringkernrückseite eines baugleichen Filterbauteils angeordnet ist, eine Rastverbindung zwischen dem Filterteil und dem baugleichen Filterteil schaffen würde.

In einem Ausführungsbeispiel einer Filterbaugruppe sind Filterbauteile baugleich ausgeführt. Dadurch können mittels eines Filterbauteiltyps durch Aneinanderreihen Ringkerne jeder Grösse zusammengesetzt werden.

In einem Ausführungsbeispiel des Systems ist der Leiter nicht an dem mindestens einen Filterbauteil oder an der Filterbaugruppe befestigt bzw. ist der Leiter lose.

In einem Ausführungsbeispiel des Systems ist die Filterbaugruppe auf einer Zwischenplatte befestigt und die Zwischenplatte auf dem Befestigungselement befestigt.

In einem Ausführungsbeispiel des Systems weist das mindestens eine Filterbauteil oder die Filterbaugruppe Ausnehmungen für die Befestigung auf, und das mindestens eine Filterbauteil oder die Filterbaugruppe wird durch diese Ausnehmungen mit Nieten oder Schrauben an dem Befestigungselement oder der Zwischenplatte befestigt.

### Kurze Beschreibung der Figuren

Die Erfindung wird anhand der beigefügten Figuren näher erläutert, wobei
**Fig. 1** eine erste dreidimensionale Ansicht eines Ausführungsbeispiels des erfindungsgemässen Bauteils;
**Fig. 2** eine zweite dreidimensionale Ansicht des Ausführungsbeispiels des erfindungsgemässen Bauteils;
**Fig. 3** eine erste Seitenansicht des Ausführungsbeispiels einer erfindungsgemässen Baugruppe;
**Fig. 4** eine zweite Seitenansicht des Ausführungsbeispiels der erfindungsgemässen Baugruppe;
**Fig. 5** eine dritte Seitenansicht des Ausführungsbeispiels der erfindungsgemässen Baugruppe;
**Fig. 6** eine vierte Seitenansicht des Ausführungsbeispiels der erfindungsgemässen Baugruppe;
**Fig. 7** den Schnitt A-A der Fig. 3 des Ausführungsbeispiels der erfindungsgemässen Baugruppe;
**Fig. 8** den Schnitt B-B der Fig. 3 des Ausführungsbeispiels der erfindungsgemässen Baugruppe;
**Fig. 9** den Schnitt D-D der Fig. 4 des Ausführungsbeispiels der erfindungsgemässen Baugruppe; und
**Fig. 10** einen Filter mit einer Filterbaugruppe zeigen.

### Wege zur Ausführung der Erfindung

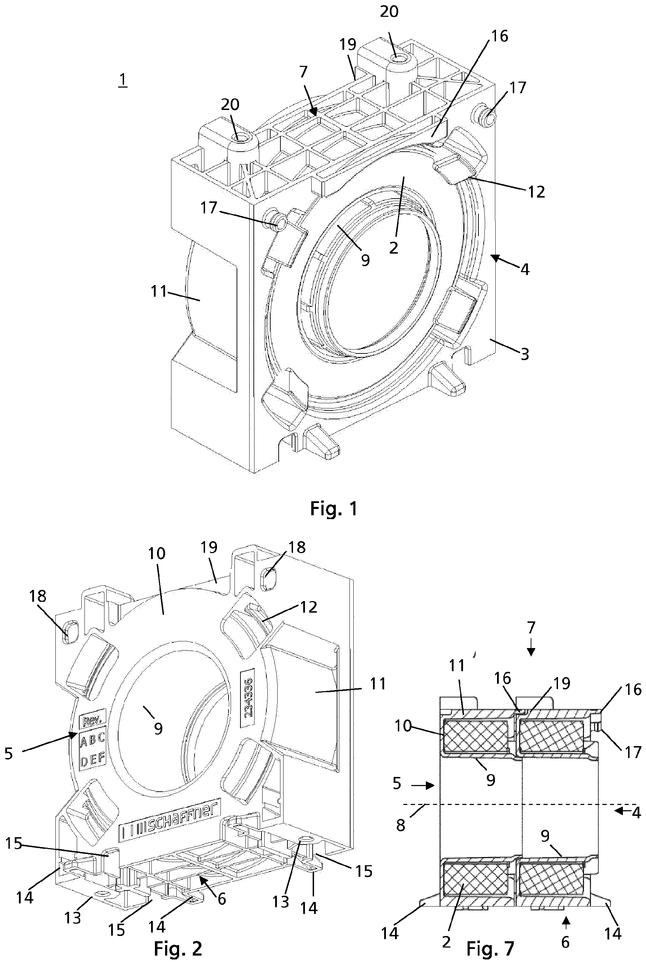

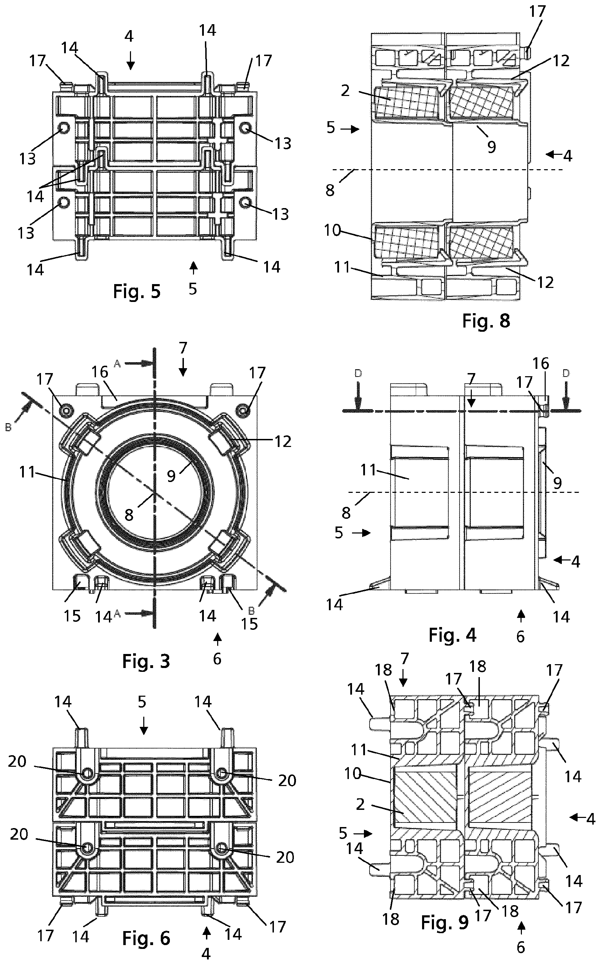

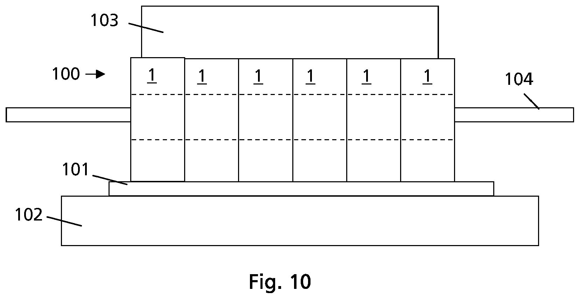

Die Figuren 1 und 2 zeigen zwei dreidimensionale Ansichten eines Ausführungsbeispiels des erfindungsgemässen Filterbauteils 1. Die Figuren 3 bis 9 zeigen verschiedene Ansichten und Schnitte eines Ausführungsbeispiels der erfindungsgemässen Filterbaugruppe 100. Fig. 10 zeigt einen Filter mit einer Filtergruppe 100.

Eine Filtergruppe weist eine Mehrzahl von Filterbauteilen 1 auf. Die in Fig. 3 bis 9 gezeigte Filterbaugruppe 100 weist zwei Filterbauteile 1 auf. Allerdings kann die Filtergruppe 100 jede andere Anzahl von Filterbauteilen 1 aufweisen. Die Filtergruppe 100 kann auch andere erfindungsgemässe Filterbauteile aufweisen als die Filterbauteile 1. In dem in Fig. 3 bis 9 gezeigten Ausführungsbeispiel handelt es sich aber um die Filterbauteile 1. In diesem Ausführungsbeispiel handelt es sich um baugleiche Filterbauteile 1 in der Filterbaugruppe. Allerdings können auch unterschiedliche Filterbauteile 1 in der Filterbaugruppe 100 verwendet werden. Die Filterbauteile 1 einer Filterbaugruppe 100 werden hintereinander gereiht, so dass diese einen grösseren Ringkern mit einer gemeinsamen Öffnung bilden, um einen Leiter, z.B. ein Kabel, eine (starre) Stromschiene oder sonstige stromführende Mittel durch die gemeinsame Öffnung zu führen. In der gezeigten Filterbaugruppe 100 sind ein erstes Filterbauteil 1 und ein zweites Filterbauteil 1 für die Filterbaugruppe 100 verwendet.

Das Filterbauteil 1 weist einen Ringkern 2 und ein Ringkerngehäuse 3 auf.

Der Ringkern 2 ist hier als kreisförmiger gerader Hohlzylinder mit einer zentralen Öffnung ausgeformt. Allerdings ist die Erfindung nicht auf eine solche Ringform beschränkt. Vielmehr ist jede Kernform mit einer zentralen Öffnung, die zur wicklungslosen Durchführung eines Leiters ausgebildet ist, möglich. Die zentrale Öffnung des Ringkerns 2 sollte eine gerade Längsachse 8 aufweisen, die vorzugsweise rechtwinklig zu den zwei Seiten des Ringkerns 2 angeordnet ist, die die Öffnung aufweisen. Der Ringkern 2 kann anstatt einer kreisrunden Form aber auch einen elliptischen, quadratischen, vieleckigen, polygonförmigen, allgemeinen oder sonstigen Querschnitt aufweisen. Vorzugsweise handelt es sich um einen geraden Hohlzylinder, d.h. die inneren und äusseren Mantelflächen des Hohlzylinders stehen senkrecht auf den Grundflächen. Allerdings sind auch schiefe Hohlzylinder möglich. Der Ringkern 2 ist in diesem Ausführungsbeispiel geschlossen. Der Ringkern 2 kann aber auch offen ausgeführt sein, das heisst, dass es keinen geschlossenen Pfad in dem Ringkern 2 gibt, der um die Öffnung herum geht. Der Ringkern 2 ist aus einem magnetischen Material, vorzugsweise aus einem ferromagnetischen Material.

Das Ringkerngehäuse 3 ist ein Gehäuse für den Ringkern 2. Das Ringkerngehäuse 3 ist vorzugsweise aus einem elektrisch isolierenden Material hergestellt. Das Ringkerngehäuse 3 weist eine Ringkernseite 4, eine der Ringkernseite 4 gegenüberliegende Ringkernrückseite 5, eine erste Befestigungsseite 6 und eine zweite Befestigungsseite 7 auf. Die Ringkernseite 4 ist in der Draufsicht in Fig. 3 gezeigt und schräg in Fig. 1. Die Ringkernrückseite 5 ist schräg in Fig. 2 gezeigt. Die erste Befestigungsseite 6 ist in der Draufsicht in Fig. 5 gezeigt und schräg in Fig. 2. Die zweite Befestigungsseite 7 ist in der Draufsicht in Fig. 6 gezeigt und schräg in Fig. 1. In diesem Ausführungsbeispiel sind die Ringkernseite 4 und die Ringkernrückseite 5 parallel zueinander angeordnet. In einem anderen Ausführungsbeispiel könnte die Ringkernseite 4 und die Ringkernrückseite 5 einen Winkel einschliessen, der aber eine Stapelung der Ringkerngehäuse 3 erlaubt. Vorzugsweise sollte dadurch eine gemeinsame Längsachse der Öffnungen der Ringkerne 2 erreicht werden. In diesem Ausführungsbeispiel ist die Befestigungsseite 6 gegenüber der zweiten Befestigungsseite 7, vorzugsweise parallel dazu angeordnet. Allerdings kann die zweite Befestigungsseite 7 auch anders angeordnet sein oder ganz entfallen. In diesem Ausführungsbeispiel ist die erste Befestigungsseite 6 rechtwinkelig zu der Ringkernseite 4 und/oder zu der Ringkernrückseite 5 angeordnet. In diesem Ausführungsbeispiel ist die erste Befestigungsseite 6 ebenfalls parallel zu der Längsachse 8 der Öffnung des Ringkerns 2, so dass bei Befestigung des Ringkerngehäuses auf einem flachen Befestigungselement, die Längsachse 8 der Öffnung des Ringkerns 2 parallel zu dem flachen Befestigungselement (bzw. zu dessen Befestigungsfläche) verläuft. Fig. 4 zeigt eine der zwei Seiten des Ringkerngehäuses 3, welche in diesem Ausführungsbeispiel neben den vier erwähnten Seiten die fünfte und sechste Seite eines Quaders ausbilden. Allerdings haben die fünfte und sechste Seite keine Funktion und könnten ebenso anders geformt sein. Die Höhe und Breite der Ringkernseite 4 und der Ringkernrückseite 5 und die Längen der anderen vier Seiten sind grösser als Durchmesser des Ringkerns 2. Die Breite der anderen vier Seiten ist grösser als die Dicke oder entspricht der Dicke des Ringkerns 2, d.h. die Dimension in Richtung der Längsachse 8 der Öffnung des Ringkerns 2.

Die erste Befestigungsseite 6 des Ringkerngehäuses 3 weist Befestigungsmittel auf, um das Ringkerngehäuse 3 mit der ersten Befestigungsseite 6 an einem Befestigungselement zu befestigen. Hier sind zwei Befestigungsausnehmungen 13 als Befestigungsmittel vorgesehen, die bevorzugterweise an den beiden Enden der längeren Seite der ersten Befestigungsseite 6 und/oder mittig in Bezug auf die kürzere Seite der ersten Befestigungsseite 6 angeordnet sind. Die Befestigungsausnehmungen 13 sind ausgebildet, Nieten und/oder Muttern aufzunehmen. Dazu befindet sich hinter den Befestigungsausnehmungen 13 ein Hohlraum, in dem sich die Niete hinter der Befestigungsausnehmung verbreitern kann. Der Hohlraum der Befestigungsausnehmung 13 ist alternativ oder zusätzlich ausgebildet, eine Mutter aufzunehmen, so dass das Ringkerngehäuse 3 angeschraubt werden kann. Die Mutter kann zum Beispiel von der Ringkernrückseite eingeschoben werden. Vorzugsweise weist der Hohlraum Mittel zur Verdrehsicherung und/oder zur Sicherung einer Positionierung der Mutter auf. Vorzugsweise ist die Befestigungsseite flach ausgebildet, um das Ringkerngehäuse 3 auf einem flachen Befestigungselement zu befestigen. In diesem Ausführungsbeispiel ist die Standfläche der ersten Befestigungsseite 6 durch vier Standfüße 14 vergrössert, die sich in der gleichen Ebene der ersten Befestigungsseite 6 aus der Ringkernseite 4 und der Ringkernrückseite 5 vorspringend erstrecken. Dies erlaubt, die Standfläche des Ringkerngehäuses 3 zu vergrössern. Das ist insbesondere vorteilhaft, wenn nur ein Ringkerngehäuse 3 oder nur eine geringe Anzahl von Ringkerngehäusen 3 befestigt wird. In diesem Ausführungsbeispiel sind zwei Standfüße 14 auf der Ringkernseite 4 und zwei Standfüße 14 auf der Ringkernrückseite 5 angeordnet. Die Standfüße 14 der Ringkernseite 4 sind versetzt zu den Standfüßen 14 der Ringkernrückseite 5 angeordnet. Dies ist in Fig. 5, 6 und 9 gut zu sehen. Gleichzeitig sind in der Ringkernseite 4 Standfußausnehmungen 15 gegenüber der Position der Standfüsse der Ringkernrückseite 5 angeordnet und in der Ringkernrückseite 5 Standfußausnehmungen 15 gegenüber der Position der Standfüße der Ringkernseite 4 angeordnet. Jede Standfußausnehmung 5 ist geeignet, einen Standfuß 14 aufzunehmen. So können zwei Filterbauteile 1 mit der Ringkernseite 4 direkt an die Ringkernrückseite 5 des zweiten Filterbauteils 1 angeordnet werden. Die Standfüße 14 der Ringkernseite 4 des ersten Filterbauteils 1 werden dabei vollständig in den Standfußausnehmungen 15 der Ringkernrückseite 5 des zweiten Filterbauteils 1 aufgenommen. Die Standfüße 14 der Ringkernrückseite 5 des zweiten Filterbauteils 1 werden dabei vollständig in den Standfußausnehmungen 15 der Ringkernseite 4 des ersten Filterbauteils 1 aufgenommen (siehe Fig. 5). So kann die Ringkernseite 4 des ersten Filterbauteils 1 flächig bündig an die Ringkernrückseite 5 des zweiten Filterbauteils 1 angeordnet werden. In dem gezeigten Ausführungsbeispiel kann die erste Befestigungsseite 6 mindestens einen Vorsprung, hier zwei Vorsprünge, aufweisen, der/die im befestigten Zustand in entsprechend geformte Ausnehmungen des Befestigungselements eingreift/eingreifen. Der Vorsprung oder die Vorsprünge sind so ausgebildet, dass das Gehäuse nur in der richten Ausrichtung auf dem Befestigungselement befestigt werden kann. Hier wird dies durch einen I-Förmigen Vorsprung und einen X-förmigen Vorsprung erreicht. Aber jede andere Form des Vorsprungs oder der Vorsprünge ist auch möglich. Dieses Prinzip wird auch Poka Yoke genannt.

Die zweite Befestigungsseite 7 des Ringkerngehäuses 3 weist ebenfalls Befestigungsmittel auf, um weitere Bauteile des Filters auf dem Filterbauteil 1 bzw. der Filterbaugruppe 100 zu befestigen. Hier sind zwei Befestigungsausnehmungen 20 als Befestigungsmittel vorgesehen, die bevorzugterweise an den beiden Enden der längeren Seite der ersten Befestigungsseite 6 und/oder ungefähr mittig in Bezug auf die kürzere der ersten Befestigungsseite 6 angeordnet sind. Die Befestigungsausnehmungen 20 sind ausgebildet, Nieten aufzunehmen. Dazu befindet sich hinter den Befestigungsausnehmungen 20 ein Hohlraum, in dem sich die Niete hinter der Befestigungsausnehmung 20 verbreitern kann. Die Filterbaugruppe 100 bildet somit durch die zweiten Befestigungsseiten 7 der Filterbauteile 1 eine Befestigungsfläche mit zumindest vier Befestigungspunkten aus, so dass auf der Filterbaugruppe 100 weitere Bauteile besonders stabil befestigt werden können. Gleichzeitig werden die Filterbauteile 1 der Filterbaugruppe durch diese Befestigung untereinander stabilisiert. In diesem Ausführungsbeispiel ist die zweite Befestigungsseite 7 flach ausgebildet. Die Befestigungsausnehmungen 20 sind in entsprechenden Vorsprüngen aus der zweiten Befestigungsseite 7 angeordnet. Dadurch wird eine beabstandete Befestigung des weiteren Bauteils erreicht und somit eine Wärmeübertragung von den Ringkernen 2 zu dem weiteren Bauteil vermieden. Die zweite Befestigungsseite 7 ist aber optional und nicht essentiell für die Erfindung.

Die Ringkernseite 4 des Ringkerngehäuses 3 weist eine Ausnehmung zum Einführen und Aufnehmen des Ringkerns 2 auf. Die Form der Ausnehmung entspricht der Projektion des Ringkerns 2 auf eine Fläche rechtwinklig zu der Längsachse 8 des Ringkerns (für einen geraden Hohlzylinder entspricht dies dem Querschnitt bzw. der Grundfläche des Hohlzylinders). Das Ringkerngehäuse 3 weist weiterhin eine Öffnung auf, die von der Ringkernseite 4 zu der Ringkernrückseite 5 verläuft. In diesem Ausführungsbeispiel ist die Längsachse der Öffnung des Ringkerngehäuses 3 identisch mit der Längsachse 8 der Öffnung des Ringkerns 2. In anderen Ausführungsbeispielen könnten diese beiden Längsachsen auch nur parallel oder sogar mit einem leichten Winkel zueinander angeordnet sein. In diesem Ausführungsbeispiel ist der Querschnitt der Öffnung des Ringkerngehäuses 3 kreisrund. Allerdings kann der Querschnitt der Öffnung des Ringkerngehäuses 3 auch andere Formen aufweisen. Vorzugsweise entspricht die Form der des Querschnitts der Öffnung des Ringkerns 2. Die Ausnehmung zum Einführen und Aufnehmen des Ringkerns 2 weist eine Aussenwand 11, eine Rückwand 10 und eine Innenwand 9 auf. Die Aussenwand 11 deckt die Aussenseite (hier Mantelfläche des Hohlzylinders) des Ringkerns 2 ab. Die Innenwand 9 deckt die Innenseite (hier Innenmantelfläche des Hohlzylinders) des Ringkerns 2 ab. Die Rückwand 10 deckt die Rückseite (hier eine der Grundflächen des Hohlzylinders) des Ringkerns 2 ab. In diesem Ausführungsbeispiel ist das Ringkerngehäuse 3, zumindest aber die Innenwand 9, die Rückwand 10 und die Aussenwand 11 aus einem elektrisch isolierenden Material. Dadurch ist der Ringkern 2 gegenüber diesen drei Seiten isoliert.

Das Ringkerngehäuse 3 weist weiterhin einen Schnappmechanismus auf, der ausgebildet ist, sich beim Einführen des Ringkerns 2 in das Ringkerngehäuse 3 zu öffnen und bei Erreichen der Position des Ringkerns 2 einzuschnappen. In dem eingeschnappten Zustand hält der Schnappmechanismus den Ringkern 2 durch Formschluss in seiner Position. In diesem Ausführungsbeispiel ist der Schnappmechanismus in der Ausnehmung der Ringkernseite 4 angeordnet. Erfindungsgemäß ist der Schnappmechanismus durch mindestens einen Schnapphebel 12 realisiert. In diesem Ausführungsbeispiel sind vier Schnapphebel 12 verwendet. Allerdings könnten auch zwei, drei, fünf oder mehr Schnapphebel 12 verwendet werden. Die Schnapphebel 12 sind in diesem Ausführungsbeispiel über den Aussenumfang des Ringkerns verteilt. Alternativ könnten diese aber auch über den Innenumfang oder beide Umfänge verteilt sein. Jeder Schnapphebel 12 ist an einem Hebelpunkt in dem Ringkerngehäuse 3, vorteilhafterweise an der Aussenwand 11 befestigt. Der Hebelpunkt ist vorzugsweise mehr Richtung Rückwand 10 als Richtung Ringkernseite 4 angeordnet, um einen möglichst langen Hebel zu erreichen. Auf der gegenüber dem Hebelpunkt angeordneten Seite des Hebelarms weist der Schnapphebel 12 einen Hebelkopf auf. Der Hebelkopf blockiert in seiner eingerasteten Stellung den in dem Ringkerngehäuse 3 eingerasteten Ringkern 2 und verhindert dessen Bewegung in Richtung der Längsachse der Öffnung und/oder der Normalen der Ringkernseite 4. In diesem Ausführungsbeispiel ist der Hebelkopf des Schnapphebels 12 so ausgebildet, dass sich der oder die Schnapphebel 12 in eine öffnende Position bewegen, wenn der Ringkern 2 in seine Position in dem Ringkerngehäuse (in der Ausnehmung) eingeführt wird. Dies wird durch eine in Richtung der Mitte des Ringkerns 2 abfallende schräge Fläche erreicht. Dadurch drückt der Ringkern 2, der beim Einführen auf die schräge Fläche stösst, durch die geschickte Ausrichtung der Schräge des Hebelkopf, die Schnapphebel 12 auseinander in eine öffnende Stellung. Dadurch kann der Ringkern 2 den Schnappmechanismus beim Einführen automatisch öffnen. In diesem Ausführungsbeispiel sind in der Aussenwand im Bereich der Schnapphebel 12 Ausbuchtungen vorgesehen, die den Bewegungsspielraum des Schnapphebels 12 von der eingerasteten Position in die offene Position, die das Einführen des Ringkerns 2 erlaubt, ermöglichen. Alternativ könnte der Abstand zwischen der Aussenwand 11 und der äusseren Seite des Ringkerns 2 so gross ausgestaltet werden, dass die Schnapphebel 12 auch ohne Ausbuchtungen genügend Bewegungsspielraum radial zu der Längsachse der Öffnung des Ringkerngehäuses haben. Zwei der vier Schnapphebel 12 sind besonders gut in dem Schnitt B-B in Fig. 8 dargestellt. Die eingerasteten Schnapphebel 12 und die Rückwand 10 der Ausnehmung verhindern somit eine Bewegung des Ringkerns in Richtung der Einführung und der Ausführung des Ringkerns 2. Eine Bewegung rechtwinklig zu dieser Bewegungsrichtung, d.h. radial dazu wird dadurch verhindert, dass die Innenseite des Ringkerns bündig an der Innenwand 9 anliegt. Die Toleranzen des Ringkerns werden mit Quetschrippen auf der Innenwand 9 aufgenommen. Somit wird durch einfachen Formschluss eine Bewegung des Ringkerns 2 radial zu der Längsachse der Innenwand verhindert. Somit ist der eingerastete Ringkern 2 einfach zu montieren und trotzdem gegenüber dem Ringkerngehäuse 3 fest positioniert. Auf der Ringkernrückseite 5 ist die Rückwand 10 im Bereich der Schnapphebel 12 ausgenommen. So können die Schnapphebel 12 z.B. durch ein Spezialwerkzeug gleichzeitig geöffnet werden, um den Ringkern 2 wieder aus dem Ringkerngehäuse zu entfernen. Gleichzeitig erlauben diese Öffnungen, auf den Ringkern 2 von der Ringkernrückseite 5 aus in Richtung Ringkernseite 4 einen Druck auszuüben, um den Ringkern 2 auch wieder aus dem Ringkerngehäuse 3 entfernen zu können. Dies ist evtl. notwendig, wenn der Ringkern 2 beschädigt wurde und ausgetauscht werden muss.

Die Ringkernseite 4 des Ringkerngehäuses 3 weist in diesem Ausführungsbeispiel weiterhin zumindest einen Vorsprung 16 auf, der gegenüber von einer entsprechenden Ausnehmung 19 auf der Ringkernrückseite 5 angeordnet ist. In der Filterbauteilgruppe 100 greift nun der Vorsprung 16 der Ringkernseite 4 des ersten Filterbauteils in die Ausnehmung 19 der Ringkernrückseite 5 des zweiten Filterbauteils 1 ein. Dadurch wird erreicht, dass die Filterbauteile 1 einer Filterbaugruppe 100 nur in einer Ausrichtung aneinander positioniert werden können. Die Wahl, welche der Ringkernseite 4 und der Ringkernrückseite 5 nun den Vorsprung oder die entsprechende Ausnehmung enthalten, ist egal. Alternativ könnte diese Funktion auch durch die Standfüsse 14 und die Standfussausnehmungen 15 erreicht werden. In diesem Ausführungsbeispiel weist die Ringkernseite 4 des Filterbauteils zusätzlich ein oder mehrere Rastelemente 17 auf, die gegenüber von auf der Ringkernrückseite 5 angeordneten Rastausnehmungen 18 angeordnet sind. Die Rastelemente 17 sind ausgebildet, bei Aneinanderdrücken zweier Filterbauteile 1 in der richtigen Positionierung, in die Rastausnehmungen 18 der Ringkernrückseite 5 des zweiten Filterbauteils 1 einzurasten. In dem eingerasteten Zustand, sind die mindestens zwei Filterbauteile 1 der Filterbaugruppe 100 miteinander befestigt und können nur durch ein Auseinanderziehen der zwei Filterbauteile 1 mit einer Kraft erreicht werden, die einen Schwellwert übersteigt. Somit kann eine Filterbaugruppe 100 mit einer beliebigen Anzahl an Filterbauteilen 1 einfach zusammengesteckt werden, ohne die einzelnen Filterbauteile 1 bis zur Befestigung auf dem Befestigungselement in Ihrer relativen Position halten zu müssen. Fig. 9 zeigt einen Schnitt durch die Filterbaugruppe 100 durch die Rastelemente 17 und die Rastausnehmungen 18. Vorzugsweise sind zwei dieser Rastelemente 17 auf der Ringkernseite 2 angeordnet. Vorzugsweise sind zwei Rastelemente 17 auf der Ringkernseite 2 in Richtung der zweiten Befestigungsseite 7 bzw. gegenüber der ersten Befestigungsseite 6 angeordnet. Dadurch werden die Filterbauteile 1 in der Filterbaugruppe 100 gegenüber der ersten Befestigungsseite 6 zusammengehalten, auch wenn kein weiteres Bauteil auf der Filterbaugruppe 100 befestigt wird oder wenn es keine zweite Befestigungsseite 7 gibt.

In diesem Ausführungsbeispiel steht die Innenwand 9 etwas über die Ringkernseite 4 des Ringkerngehäuses 3 hinaus. Im Bereich dieses Vorsprungs verjüngt sich der durch die Innenwand 9 gebildete Konus im Durchmesser kontinuierlich oder gestuft. Die Ringkernrückseite 5 weist eine Aufnahmeausnehmung auf, um diesen verjüngten Konus der Innenwand 9 aufzunehmen. Die Aufnahmeausnehmung ist hier ebenfalls durch die Innenwand 9 realisiert. Da durch die Innenwand 9 auch die Öffnung für die Durchführung eines Leiters in dem Ringkerngehäuse 3 gebildet wird, wird durch das Eingreifen der verjüngten Innenwand 9 an der Ringkernseite 4 des ersten Filterbauteils 1 in die Innenwand 9 an der Ringkernrückseite 5 des zweiten Filterbauteils 1 erreicht, dass die Öffnungen der Ringkerngehäuse 3 zueinander ausgerichtet werden.

Fig. 10 zeigt nun eine schematische Anordnung eines Filters, z.B. ein EMV-Filter (EMV: elektromagnetische Verträglichkeit). Der Filter wird auf einem Befestigungselement 102 befestigt. Der Filter weist eine optionale Zwischenplatte 101, eine Filterbaugruppe 100 mit einer Mehrzahl an Filterbauteilen 1, ein optionales weiteres Bauteil 103 und einen Leiter 104 auf. Die Filterbaugruppe 100 ist auf der Zwischenplatte 101 befestigt, wobei diese dann auf dem Befestigungselement 102 befestigt wird. Allerdings kann die Filterbaugruppe 100 auch direkt auf dem Befestigungselement 102 befestigt werden. Die zusammengesetzten Filterbauteile 1 der Filterbaugruppe 100 werden auf die Zwischenplatte 101 oder auf das Befestigungselement 102 genietet. Dazu werden die Nieten durch die zwei Befestigungsausnehmungen 13 eines jeden Filterbauteils 1 geführt und befestigt. Alternativ können aber auch Schrauben und andere Befestigungsmittel verwendet werden. Optional ist ein weiteres Bauteil 103 auf der Filterbaugruppe 100 befestigt. Dazu wird das weitere Bauteil 103 durch die Befestigungsausnehmungen 20 der Filterbauteile 1 der Filterbaugruppe 100 genietet oder auf sonstige Weise befestigt. Das weitere Bauteil 103 kann auch nur zur Stabilisierung der Filterbauteile 1 der Filterbaugruppe 100 untereinander dienen. Somit kann die Filterbaugruppe 100 bereits ohne die zu filternden Leiter 104 befestigt werden. Der oder die Leiter 104 können zum Schluss durch die Öffnung der Filterbaugruppe 100, d.h. durch die Öffnungen der Ringkerne 2 und der Ringkerngehäuse 3 der Filterbauteile 1, geführt werden. Eine Befestigung der wicklungslosen Ringkerne 2 an dem Leiter 104 ist nicht mehr notwendig. Somit entfallen aufwendige Befestigungen der wicklungslosen Ringkerne 2 an dem Leiter 104. Gleichzeitig ist aber der wicklungslose Ringkern 2 befestigt. Der Leiter 104 kann ein Kabel oder eine starre Leiterschiene sein. Im Falle einer starren Leiterschiene ist es von Vorteil, diese ebenfalls an dem Befestigungselement 102 oder der Zwischenplatte 101 zu befestigen, so dass die Leiterschiene relativ zu den Ringkernen 2 fest positioniert ist. In einem alternativen Ausführungsbeispiel kann die Filterbaugruppe 100 auch nur ein Filterbauteil 1 aufweisen.

Ein Vorteil der Erfindung ist, dass eine aufwendige Befestigung des Leiters an den Filterbauteilen 1 bzw. den Ringkernen 2 nicht notwendig ist.

Ein weiterer Vorteil ist, dass der Zusammenbau, die Variation der Grösse und die Befestigung der Filterbaugruppe 100 besonders einfach sind. Je nach notwendiger Grösse des wicklungslosen Ringkerns 2 wird die Anzahl der Filterbauteile 1 der Filterbaugruppe 100 gewählt. Für jedes Filterbauteil wird der Ringkern 2 in das Ringkerngehäuse 3 gesteckt. Alle Filterbauteile werden zusammengesteckt (gestapelt), so dass sich der Ringkern der gewünschten Grösse ergibt. Jetzt muss nur noch die so zusammengebaute Filterbaugruppe 100 befestigt werden und ein Leiter 104 durch die Öffnung der Filterbaugruppe 100 geführt werden.

## Patentansprüche

1. Filterbauteil aufweisend:
einen wicklungslosen magnetischen Ringkern (2) mit einer Öffnung;
ein Ringkerngehäuse (3), in dem der Ringkern (2) mit einem Mechanismus befestigt ist, der so ausgebildet ist, dass der Ringkern (2) in Richtung einer Längsachse der Öffnung des Ringkerns (2) in das Ringkerngehäuse (3) gesteckt werden kann;
wobei das Filterbauteil (1) so ausgebildet ist, dass ein Leiter (104) wicklungslos durch die Öffnung des in dem Ringkerngehäuse (3) befestigten Ringkerns (2) geführt werden kann, **dadurch gekennzeichnet, dass**
der Mechanismus ein Schnappmechanismus ist, der einen oder mehrere bewegliche Hebel (12) aufweist, die so geformt sind, dass sich der oder die bewegliche(n) Hebel (12) beim Drücken des Ringkerns (2) gegen das Ringkerngehäuse (3) öffnen und nach dem Einschnappen des oder der beweglichen Hebel (12) den Ringkern (2) unmittelbar halten.

2. Filterbauteil nach Anspruch 1, wobei der Ringkern eine hohlzylindrische Form hat, und die beweglichen Hebel (12) so geformt sind, dass die beweglichen Hebel (12) beim Drücken des Ringkerns (2) gegen das Ringkerngehäuse (3) sich in radialer Richtung und weg von der Längsachse der Öffnung in eine öffnende Stellung gedrückt werden.

3. Filterbauteil nach einem der Ansprüche 1 bis 2, wobei der Ringkern (2) in einer dem Ringkern (2) entsprechenden Ausnehmung des Ringkerngehäuses (3) angeordnet ist.

4. Filterbauteil nach einem der Ansprüche 1 bis 3, wobei das Ringkerngehäuse (3) eine Innenwandung (9) aufweist, die eine Wandung des Ringkerns (2) in dessen Öffnung bedeckt, und eine Aussenwandung (11) aufweist, die die der Öffnung gegenüberliegende äussere Wandung des Ringkerns (2) bedeckt.

5. Filterbauteil nach einem der Ansprüche 1 bis 4, wobei das Ringkerngehäuse (3) eine erste Befestigungsfläche (6) zur Befestigung des Ringkerngehäuses (3) aufweist, die parallel zu der Längsachse (8) der Öffnung des Ringkerns (2) angeordnet ist.

6. Filterbauteil nach Anspruch 5, wobei das Ringkerngehäuse (3) eine zweite Befestigungsfläche (7) zur Befestigung eines weiteren Bauteils (103) auf dem Ringkerngehäuse (3) aufweist, die parallel zu der Längsachse (8) der Öffnung des Ringkerns (2) angeordnet ist.

7. Filterbauteil nach Anspruch 6, wobei die erste Befestigungsfläche (6) parallel zu der zweiten Befestigungsfläche (7) angeordnet ist.

8. Filterbauteil nach einem der Ansprüche 5 bis 7, wobei die erste Befestigungsfläche (6) und/oder die zweite Befestigungsfläche (7) Ausnehmungen (13, 20) für Befestigungsmittel aufweist.

9. Filterbauteil nach einem der Ansprüche 5 bis 8, wobei die erste Befestigungsfläche (6) vier vorspringende Standfüsse (14) zur Vergrösserung der Standfläche des Ringkerngehäuses (3) aufweist, wobei das Ringkerngehäuse (3) eine Ringkernseite (4) zum Einführen des Ringkerns (2) und eine der Ringkernseite (4) gegenüberliegende Ringkernrückseite (5) aufweist, wobei die Ringkernseite (4) zwei in Richtung der Längsachse (8) der Öffnung vorspringende Standfüße (14) aufweist und die Ringkernrückseite (5) zwei in Richtung der Längsachse (8) der Öffnung vorspringende Standfüße (14) aufweist, die zu den zwei Standfüßen (14) der Ringkernseite (4) versetzt angeordnet sind, wobei die Ringkernseite (4) zwei Standfußausnehmungen (15) für die Aufnahme jeweils eines Standfußes (14) aufweist, die gegenüber den zwei Standfüßen (14) der Ringkernrückseite (5) angeordnet sind, und die Ringkernrückseite (5) zwei Standfußausnehmungen (15) für die Aufnahme jeweils eines Standfußes (14) aufweist, die gegenüber den zwei Standfüßen (14) der Ringkernseite (4) angeordnet sind.

10. Filterbauteil nach einem der Ansprüche 1 bis 9, wobei das Ringkerngehäuse (3) eine Ringkernseite (4) zum Einführen des Ringkerns und eine der Ringkernseite (4) gegenüberliegende Ringkernrückseite (5) aufweist, wobei die Ringkernseite (4) und die Ringkernrückseite (5) des Ringkerngehäuses (3) so ausgebildet sind, dass, wenn das Filterbauteil (1) mit der Ringkernseite (4) im Anschluss an eine Ringkernrückseite (5) eines baugleichen Filterbauteils (1) angeordnet ist, eine zu der Längsachse (8) der Öffnung des Ringkerns (2) radiale relative Bewegung der beiden Filterbauteile (1) durch Formschluss verhindert wird.

11. Filterbauteil nach Anspruch 10, wobei die Ringkernseite (4) und die Ringkernrückseite (5) des Ringkerngehäuses (3) so ausgebildet sind, dass, wenn das Filterbauteil (1) mit der Ringkernseite (4) im Anschluss an eine Ringkernrückseite (5) eines baugleichen Filterbauteils (1) angeordnet ist, die Anordnung nur in einer Positionierung möglich ist.

12. Filterbauteil nach Anspruch 10 oder 11, wobei die Ringkernseite (4) und die Ringkernrückseite (5) des Ringkerngehäuses (3) jeweils Rastelemente (17, 18) aufweisen, die, wenn das Filterbauteil (1) mit der Ringkernseite (4) im Anschluss an eine Ringkernrückseite (5) eines baugleichen Filterbauteils (1) angeordnet ist, eine Rastverbindung zwischen dem Filterteil und dem baugleichen Filterteil schaffen würde.

13. Filterbaugruppe aufweisend eine Mehrzahl von Filterbauteilen nach einem der vorigen Ansprüche mit jeweils einem Ringkern (2) und einem Ringkerngehäuse (3), wobei jedes Ringkerngehäuse (3) eine Ringkernseite (4) und eine der Ringkernseite (4) gegenüberliegende Ringkernrückseite (5) aufweist, wobei die Mehrzahl von Filterbauteilen gestapelt angeordnet sind, so dass die Ringkernseite (4) eines der Filterbauteile (1) an der Ringkernrückseite (5) eines benachbarten Filterbauteils (1) anliegt.

14. System aufweisend:
ein Befestigungselement (102);
mindestens ein Filterbauteil (1) nach einem der Ansprüche 1 bis 12 oder eine Filterbaugruppe (100) nach Anspruch 13, das oder die auf dem Befestigungselement (102) befestigt ist;
ein Leiter (104), der wicklungslos durch die Öffnung jedes Ringkerns (2) des mindestens einen Filterbauteils (1) oder der Filterbaugruppe (100) geführt ist.

15. Verfahren aufweisend die Schritte:
Befestigen einer Filterbaugruppe (100) nach Anspruch 13 oder eines Filterbauteils (1) nach einem der Ansprüche 1 bis 12 auf einem Befestigungselement (1); und
Durchführen eines Leiters durch eine Öffnung des Ringkerns (2) oder der Ringkerne (2) nach dem Befestigen der Filterbaugruppe (100) oder des Filterbauteils (1).

## Claims

1. Filter component having:
a windingless magnetic ring core (2) with an opening;
a ring core housing (3), in which the ring core (2) is fastened with a mechanism which is designed such that the ring core (2) can be inserted in the direction of a longitudinal axis of the opening of the ring core (2) in the ring core housing (3);
wherein the filter component (1) is designed such that a conductor (104) can be run windinglessly through the opening of the ring core (2) fastened in the ring core housing (3);
**characterized in that**
the mechanism is a snap-fit mechanism which has one or more movable levers (12) that are formed such that the one or more movable levers (12) open when the ring core (2) is pressed against the ring core housing (3) and hold the ring core (2) directly after the one or more levers (12) have snapped-in.

2. Filter component according to claim 1, wherein the ring core has a form of a hollow cylinder and the movable levers (12) are formed in such a way that the movable levers open in a direction radially away from the longitudinal axis of the opening of the ring core (2), when the ring core (2) is pressed against the ring core housing (3).

3. Filter component according to one of the claims 1 to 2, wherein the ring core (2) is arranged in a recess of the ring core housing (3) corresponding to the ring core (2).

4. Filter component according to one of the claims 1 to 3, wherein the Ring core housing (3) has an inner wall (9) that covers the wall of the ring core (2) in its opening, and an outer wall (11) that covers the outer wall of the ring core (2) opposite the opening.

5. Filter component according to one of the claims 1 to 4, wherein the ring core housing (3) has a first fastening surface (6) for fastening the ring core housing (3), arranged in parallel to a longitudinal axis (8) of the opening of the ring core (2).

6. Filter component according to claim 5, wherein the ring core housing (3) has a second fastening surface (7) for fastening a further component (103) onto the ring core housing (3), arranged in parallel to the longitudinal axis (8) of the opening of the ring core (2).

7. Filter component according to claim 6, wherein the first fastening surface (6) is placed in parallel to the second fastening surface (7).

8. Filter component according to one of the claims 5 to 7, wherein the first fastening surface (6) and/or the second fastening surface (7) have recesses (13, 20) for fastening means.

9. Filter component according to one of claims 5 to 8, wherein the first fastening surface (6) has four protruding feet (14) for increasing the footprint of the ring core housing (3), wherein the ring core housing (3) has a ring core side (4) for inserting the ring core (2) and a ring core rear side (5) opposite the ring core side (4), wherein the ring core side (4) has two feet (14) protruding in the direction of the longitudinal axis (8) of the opening and the ring core rear side (5) has two feet (14) protruding in the direction of the longitudinal axis (8) of the opening, and which are arranged in an offset fashion to the two feet (14) of the ring core side (4), wherein the ring core side (4) has two feet recesses (15) for each accommodating one of the feet (14) and arranged opposite the two feet (14) of the ring core rear side (5), and wherein the ring core rear side (5) has two feet recesses (15) for each accommodating one of the feet (14) and arranged opposite the two feet (14) of the ring core side (4).

10. Filter component according to one of the claims 1 to 9, wherein the ring core housing (3) has a ring core side (4) for inserting the ring core and a ring core rear side (5) opposite the ring core side (4), wherein the ring core side (4) and the ring core rear side (5) of the ring core housing (3) are designed such that, when the filter component (1) is placed with the ring core side (4) in connection to a ring core rear side (5) of a filter component (1) of same construction, a radial movement of the two filter components (1) relative to the longitudinal axis (8) of the opening of the ring core (2) is prevented due to perfect form-fit.

11. Filter component according to claim 10, wherein the ring core side (4) and the ring core rear side (5) of the ring core housing (3) are designed such that when the filter component (1) is placed with the ring core side (4) connected to a ring core rear side (5) of a filter component (1) of same construction, the arrangement is possible only in one positioning.

12. Filter component according to claim 10 or 11, wherein the ring core side (4) and the ring core rear side (5) of the ring core housing (3) have each snap-fit elements (17, 18) which, when the filter component (1) is placed with the ring core side (4) connected to a ring core rear side (5) of a filter component (1) of same construction, would create a snap-fit connection between the filter component and the filter component of same construction.

13. Filter assembly with a plurality of filter components according to one of the preceding claims, each with a ring core (2) and a ring core housing (3), wherein each ring core housing (3) has a ring core side (4) and a ring core rear side (5) opposite the ring core side (4), wherein the plurality of filter components are placed in a stacked manner, so that the ring core side (4) of one of the filter components (1) abuts to the ring core rear side (5) of a neighboring filter component (1).

14. System having:
a fastening element (102);
at least one filter component (1) according to one of the claims 1 to 12 or one filter assembly (100) according to claim 13, which is or are fastened onto the fastening element (102);
a conductor (104) that can be run windinglessly through the opening of each ring core (2) of the at least one filter component (1) or of the filter assembly (100).

15. Method with the steps of:
fastening a filter assembly (100) according to claim 13 or a filter component (1) according to one of the claims 1 to 12 onto a fastening element (1); and
running a conductor via an opening of the ring core (2) or the ring cores (2) after fastening of the filter assembly (100) or of the filter component (1).
Filter component having a windingless magnetic ring core with an opening, a ring core housing in which the ring core is fastened using a snap-on mechanism, wherein the filter component is designed such that a conductor can be run windinglessly through the opening of the ring core fastened in the ring core housing.

## Revendications

1. Composant de filtre comprenant:
un noyau toroïdal sans enroulement (2) avec une ouverture ;
un boîtier toroïdal (3) est fixé dans lequel le noyau toroïdal (2) au moyen d'un mécanisme agencé de telle sorte que le noyau toroïdal (2) peut être placé dans le boîtier toroïdal (3) dans la direction d'un axe longitudinal de l'ouverture du noyau toroïdal (2) ;
le composant de filtre (1) étant formé de telle sorte qu'un conducteur (104) peut être introduit sans effet à travers l'ouverture du noyau toroïdal (2) fixé dans le boîtier toroïdal (3),
**caractérisé en ce que**
le mécanisme est un mécanisme d'enclenchement qui comprend un ou plusieurs levier(s) mobile(s) formés de telle sorte que le ou les plusieurs levier(s) mobile(s) (12) s'ouvrent lorsque le noyau toroïdal (2) est pressé contre le boîtier toroïdal (3), et après enclenchement du ou des levier(s) mobile(s) (12) maintiennent directement le noyau toroïdal (2).

2. Composant de filtre selon la revendication 1, dans lequel le noyau toroïdal (2) a une forme de cylindre creux et les leviers mobiles (12) sont formés de telle sorte que les leviers mobiles (12), lorsque le noyau toroïdal (2) est pressé contre le boîtier toroïdal (3), sont pressés dans une position ouverte en direction radiale et en éloignement de l'axe longitudinal de l'ouverture.

3. Composant de filtre selon l'une des revendications 1 à 2, le noyau toroïdal (2) étant agencé dans un évidement du boîtier toroïdal (3) correspondant au noyau toroïdal (2).

4. Composant de filtre selon l'une des revendications 1 à 3, le boîtier toroïdal (3) possède une paroi intérieure (9) qui recouvre une paroi du noyau toroïdal (2) dans une ouverture de celui-ci, et une paroi extérieure (11) qui recouvre une paroi extérieure du noyau toroïdal (2) en face de l'ouverture.

5. Composant de filtre selon une des revendications 1 à 4, dans lequel le noyau toroïdal (3) possède une surface de fixation (6) pour fixer le boîtier toroïdal (3) qui est agencé en parallèle à l'axe longitudinal (8) de l'ouverture du noyau toroïdal (2).

6. Composant de filtre selon la revendication 5, dans lequel le boîtier toroïdal (3) possède une deuxième surface de fixation (7) pour fixer un autre composant (103) sur le boîtier toroïdal (3), qui est agencé en parallèle à l'axe longitudinal (8) de l'ouverture du noyau toroïdal (2).

7. Composant de filtre selon la revendication 6, dans lequel la première surface de fixation (6) est agencée en parallèle à la deuxième surface de fixation (7).

8. Composant de filtre selon une des revendications 5 à 7, dans lequel la première surface de fixation (6) et/ou la deuxième surface de fixation (7) a des évidements (13, 20) pour des moyens de fixation.

9. Composant de filtre selon une des revendications 5 à 8, dans lequel la première surface de fixation (6) possède quatre pieds en saillie (14) pour agrandir la surface au sol du boîtier toroïdal (3), dans lequel le boîtier toroïdal (3) possède une face avant de noyau toroïdal (4) pour l'insertion du noyau toroïdal (2) et une face arrière de noyau toroïdal (5) opposée à la face avant de noyau toroïdal (4), la face avant de noyau toroïdal (4) ayant deux pieds (14) en saillie en direction de l'axe longitudinal (8) de l'ouverture et la face arrière du noyau toroïdal (5) ayant deux pieds (15) en saillie en direction de l'axe longitudinal (8) de l'ouverture, qui sont agencés de façon décalée par rapport aux deux pieds (14) de la face avant de noyau toroïdal (2), la face avant de noyau toroïdal (4) ayant deux évidements pour pieds (15) pour chacun accueillir un pied (14), agencés en face deux deux pieds (14) de la face arrière de noyau toroïdal (5), et la face arrière de noyau toroïdal (5) ayant deux évidements pour pieds (15) pour chacun accueillir un pied (14), agencés en face deux deux pieds (14) de la face avant de noyau toroïdal (4).

10. Composant de filtre selon une des revendications 1 à 9, dans lequel le boîtier toroïdal (3) possède une face avant de noyau toroïdal (4) pour l'insertion du noyau toroïdal et une face arrière de noyau toroïdal (5) opposée à la face avant de noyau toroïdal (4), la face avant de noyau toroïdal (4) et la face arrière de noyau toroïdal (5) étant formés de telle sorte que lorsque le composant de filtre (1) est placé avec la face avant de noyau toroïdal (4) en raccordement à une face arrière de noyau toroïdal (5) d'un composant de filtre (1) de même construction, un mouvement relatif des deux composants de filtre (1) radial à l'axe longitudinal (8) de l'ouverture du noyau toroïdal (2) est empêché par complémentarité de forme.

11. Composant selon la revendication 10, dans lequel la face avant du noyau toroïdal (4) et la face arrière du noyau toroïdal (5) du boîtier toroïdal (3) sont formés de telle sorte que, lorsque le composant de filtre (1) est placé avec la face avant de noyau toroïdal (4) en raccordement à une face arrière de noyau toroïdal (5) d'un composant de filtre (1) de même construction, l'agencement n'est possible que dans un positionnement.

12. Composant selon la revendication 10 ou 11, dans lequel la face avant du noyau toroïdal (4) et la face arrière du noyau toroïdal (5) du boîtier toroïdal (3) possèdent des éléments d'encliquetage (17, 18) qui, lorsque le composant de filtre (1) est placé avec la face avant de noyau toroïdal (4) en raccordement à une face arrière de noyau toroïdal (5) d'un composant de filtre (1) de même construction, une connexion par encliquetage est créé entre l'élément de filtre et l'élément de filtre de même construction.

13. Assemblage de filtre comprenant une pluralité de composants de filtre selon une des revendications précédentes, avec à chaque fois un noyau toroïdal (2) et un boîtier toroïdal (3), dans lequel chaque boîtier toroïdal (3) possède une face avant de noyau toroïdal (4) et une face arrière de noyau toroïdal (5) opposée à la face avant de noyau toroïdal (4), la pluralité de composants de filtres étant agencée empilés les uns sur les autres, en sorte que la face avant de noyau toroïdal (4) d'un des composants de filtre (1) est placé contre la face arrière de noyau toroïdal (5) d'un composant de filtre (1) voisin.

14. Système comprenant :
un élément de fixation (102) ;
au moins un composant de filtre (1) selon une des revendications 1 à 12 ou un assemblage de filtre (100) selon la revendication 13, qui est/sont fixé(s) sur l'élément de fixation (102) ;
un conducteur (104), qui peut être introduit sans effet à travers l'ouverture de chaque noyau toroïdal (2) du au moins un composant de filtre (1) ou de l'assemblage de filtre (100).

15. Procédé comprenant les étapes suivantes :
fixation d'un assemblage de filtre (100) selon la revendication 13 ou d'un assemblage de filtre (1) selon une des revendications 1 à 12 sur un élément de fixation (1) ; et
introduction d'un conducteur à travers une ouverture du noyau toroïdal (2) ou des noyaux toroïdaux (2) après fixation de l'assemblage de filtre (100) ou du composant de filtre (1).
